# EUROPÄISCHE PATENTANMELDUNG

(11) **EP 3 557 326 A1**
(43) Veröffentlichungstag der Anmeldung: **23.10.2019**
(21) Anmeldenummer: 18167773.3
(22) Anmeldetag: 17.04.2018
(51) Int. Cl.: G03F 7/20, B23K 26/08, B23Q 1/62, H01L 21/68

(54) **POSITIONIERVORRICHTUNG ZUM POSITIONIEREN EINES OBJEKTES INNERHALB EINER EBENE IN WENIGSTENS ZWEI FREIHEITSGRADEN**

(71) Anmelder: Schneeberger Holding AG, 4914 Roggwil (CH)
(72) Erfinder: MONTILLA, Manuel, 4312 Magden (CH)
(74) Vertreter: EGLI-EUROPEAN PATENT ATTORNEYS

(57) **Zusammenfassung**

Die vorliegende Erfindung betrifft eine Positioniervorrichtung (1) zum Positionieren eines Objektes innerhalb einer Ebene, mit einem Objektträger (10) zum Aufnehmen des zu positionierenden Objekts, welcher parallel zur Ebene in wenigstens zwei Freiheitsgraden (X, Y) relativ zu einem Basiselement (20) mittels einer wenigstens zweidimensionalen Makro-Verschiebeeinrichtung (100) sowie einer in deren bewegten System integrierten wenigstens zweidimensionalen Mikro-Verschiebeeinrichtung (200) positionierbar ist, mit einer Positionsbestimmungs-Einrichtung zum Bestimmen der Position des Objektträgers (10) relativ zum Basiselement (20) und mit einer Steuereinrichtung, die zum geregelten Positionieren des Objekts mit der Makro- und der Mikro-Verschiebeeinrichtung (100, 200) sowie der Positionsbestimmungs-Einrichtung wirkverbunden ist. Gemäss der Erfindung ist es vorgesehen, dass die Positionsbestimmungs-Einrichtung (300) dazu eingerichtet ist, die Absolutposition des Objektträgers (10) in den wenigstens zwei Freiheitsgraden (X, Y) direkt in Bezug auf ein relativ zum Basiselement (20) ortsfestes Referenzsystem (301) zu bestimmen.

## Beschreibung

Die vorliegende Erfindung betrifft eine Positioniervorrichtung gemäss dem Oberbegriff des Anspruchs 1, die zum Positionieren eines Objektes innerhalb einer Ebene in wenigstens zwei Freiheitsgraden, insbesondere zum hochpräzisen Positionieren mit hohen Geschwindigkeiten und langen Verfahrwegen dient.

Viele Herstellungsprozesse in der Halbleiterindustrie erfordern eine hochpräzise Positionierung der zu prozessierenden Objekte in mehreren Freiheitsgraden, beispielweise eine hochpräzise und stabile Positionierung von Wafern innerhalb einer Ebene in drei Freiheitsgraden relativ zu einer Inspektionseinheit. Neben den steigenden Anforderungen an die Positionsgenauigkeit im Mikrometer- und Submikrometer-Bereich wächst gleichzeitig auch im zunehmenden Masse - getrieben von dem Wunsch nach einer Steigerung der Prozesseffizienz - das Bedürfnis nach einer Positionierbarkeit von mitunter grossmessenden Objekten über lange Verfahrwege mit möglichst hohen Verfahrgeschwindigkeiten. Um einerseits die Anforderungen an die Präzision und andererseits die Anforderungen an Geschwindigkeit und lange Transportwege zu erfüllen, kommen im Stand der Technik seit längerem gestufte bzw. kaskadierte Positioniervorrichtungen zum Einsatz, die eine Makro-Verschiebeeinrichtung für die Grob-Positionierung über lange Verfahrwege mit hohen Geschwindigkeiten sowie eine im bewegten System der Makro-Verschiebeeinrichtung angeordnete und damit gekoppelte Mikro-Verschiebeeinrichtung für die hochpräzise Fein-Positionierung aufweisen.

Eine solche Positioniervorrichtung mit einer Makro- bzw. Grob-Verschiebeeinrichtung sowie einer Mikro- bzw. Fein-Verschiebeeinrichtung, die zum Positionieren eines Objektes innerhalb einer Ebene in drei Freiheitsgraden (zwei Linearachsen in der Ebene und eine Rotationsachse senkrecht zur Ebene) dient, ist beispielsweise in dem Artikel "A Newly Developed X-Y Planar Nano-Motion Table System with Large Travel Ranges", Journal of Advanced Mechanical Design, Systems, and Manufacturing, Vol. 4, No. 5, 2010, 976-984, beschrieben. Die dort offenbarte Positioniereinheit verfügt über einen Objektträgertisch zur Aufnahme eines zu positionierenden Objekts, der im bewegten System einer zweiachsigen Fein-Verschiebeeinrichtung mit Voice-Coil-Antrieb angeordnet und zusätzlich berührungslos über ein Luftkissen auf einem Basiselement gelagert ist. Das Voice-Coil-Verschiebesystem befindet sich wiederum im bewegten System einer zweiachsigen Grob-Verschiebeeinrichtung mit Linearmotoren, die auf dem Basiselement angeordnet ist. Insgesamt ist dadurch der Objektträgertisch relativ zum Basiselement über einen zweistufigen Verschiebemechanismus berührungslos gelagert und positionierbar. Zum Positionieren weist die Vorrichtung zwei Regelschleifen auf: eine erste Regelschleife zur Regelung der Absolutposition der Mikro-Verschiebeeinrichtung im Bezug zum Basiselement und eine zweite Regelschleife zur Regelung der Relativposition zwischen Makro- und Mikro-Verschiebeeinrichtung. Die Absolutposition der Mikro-Verschiebeeinrichtung wird über ein Laser-Interferometersystem gemessen, wohingegen die Relativposition zwischen Makro- und Mikro-Verschiebeeinrichtung durch einen Sensor im bewegten System der Makro-Verschiebeeinrichtung ermittelt wird. Dabei wird die gemessene Relativposition zwischen Makro- und Mikro-Verschiebeeinrichtung dazu verwendet, die Position der Spulen des Voice-Coil-Antriebs im bewegten System der Makro-Verschiebeeinrichtung relativ zum Magnetsystem des Voice-Coil-Antriebs im bewegten System der Mikro-Verschiebeeinrichtung konstant zu halten. In der Praxis hat sich jedoch gezeigt, dass die Messung und Regelung der Relativposition zwischen Makro- und Mikro-Verschiebeeinrichtung für viele Hochpräzisionsanwendungen nicht ausreicht, um eine hinreichend genaue und stabile Positionierung über zwei Verschiebestufen zu gewährleisten. Auch ist die Positionsmessung per Laserinterferometer unter atmosphärischen Umgebungsbedingungen häufig mit Messfehlern behaftet, vornehmlich aufgrund von Turbulenzen bzw. Dichteschwankungen des Mediums (z.B. Luft), die durch Luftströmungen oder die eigene Bewegung der Positioniervorrichtung hervorgerufen werden.

Die Aufgabe der vorliegenden Erfindung besteht somit darin, eine Positioniervorrichtung zum präzisen Positionieren eines Objekts innerhalb einer Ebene in wenigstens zwei Freiheitsgraden, insbesondere mit langen Verfahrwegen und hohen Geschwindigkeiten anzugeben, die im Vergleich zu den aus dem Stand der Technik bisher bekannten Vorrichtungen im Hinblick auf Präzision und Stabilität deutlich verbessert ist.

Diese Aufgabe wird durch eine Positioniervorrichtung gemäss Anspruch 1 gelöst. Vorteilhafte Ausgestaltungen der Erfindung sind Gegenstand der abhängigen Ansprüche.

Die erfindungsgemässe Positioniervorrichtung umfasst einen Objektträger zum Aufnehmen des zu positionierenden Objekts, welcher mittels einer wenigstens zweidimensionalen Makro-Verschiebeeinrichtung sowie einer damit gekoppelten, wenigstens zweidimensionalen Mikro-Verschiebeeinrichtung in wenigstens zwei Freiheitsgraden innerhalb der Ebene relativ zu einem Basiselement positionierbar ist. Die Positioniervorrichtung umfasst ferner eine Positionsbestimmungs-Einrichtung zum Bestimmen der Position des Objektträgers relativ zum Basiselement sowie eine Steuereinrichtung, die zum geregelten Positionieren des Objekts mit der Positionsbestimmungs-Einrichtung sowie der Makro- und der Mikro-Verschiebeeinrichtung regelungstechnisch wirkverbunden ist.

Gemäss der Erfindung ist es vorgesehen, dass die Positionsbestimmungs-Einrichtung dazu eingerichtet ist, die Absolutposition des Objektträgers in den wenigstens zwei Freiheitsgraden direkt in Bezug auf ein relativ zum Basiselement ortsfestes Referenzsystem zu bestimmen.

Dadurch wird, insbesondere bei langen Verfahrwegen, eine Position auf eine Art und Weise, die schnelles und präzises Positionieren des Objektträgers ermöglicht, bestimmt. Es versteht sich von selbst, dass das genaue Positionieren des Objektträgers dabei Voraussetzung für das genaue Positionieren des zu positionierenden Objekts ist.

Die Position des Objektträgers wird demnach nicht durch eine Addition der Position des bewegten Systems der Makro-Verschiebeeinrichtung und der Relativposition zwischen Makro-Verschiebeeinrichtung und Mikro-Verschiebeeinrichtung bestimmt.

Die Mikro-Verschiebeeinrichtung ist dabei bevorzugt im bewegten System der Makro-Verschiebeeinrichtung angeordnet. Die Bezeichnung "bewegtes System" der Makro- bzw. Mikro-Verschiebeeinrichtung bezieht sich jeweils auf jenes System, das mithilfe der Makro- bzw. Mikro-Verschiebeeinrichtung gegenüber einem relativ dazu "stationären System" der Makro- bzw. Mikro-Verschiebeeinrichtung verschoben werden kann. Das stationäre System der Makro- und. Mikro-Verschiebeeinrichtung bezieht sich jeweils auf die Bauteile der Positioniervorrichtung, die nicht mithilfe der Makro- bzw. Mikro-Verschiebeeinrichtung bewegt werden.

Dabei ist zu beachten, dass bei der vorliegenden kaskadierten Anordnung der Makro- und Mikro-Verschiebeeinrichtung das "stationäre System" der Mikro-Verschiebeeinrichtung im "bewegten System" der Makro-Verschiebeeinrichtung angeordnet und damit gegenüber dem Basiselement und dem Referenzsystem bewegt ist. Es kann daher als Aufgabe der Makro-Verschiebeeinrichtung gesehen werden, die Reichweite der Mikro-Verschiebeeinrichtung zu vergrössern: Da sich die Mikro-Verschiebeeinrichtung, die für sich genommen eine vergleichsweise geringe Reichweite aufzuweisen braucht, im bewegten System der Makro-Verschiebeeinrichtung bewegt und die Makro-Verschiebeeinrichtung eine vergleichsweise grosse Reichweite aufweist, kann der Objektträger überall innerhalb der Reichweite der Makro-Verschiebeeinrichtung präzise positioniert werden. Die Reichweite der Makro-Verschiebeeinrichtung, d.h. deren maximale Verfahrwege, betragen bevorzugt für jeden Bewegungsfreiheitsgrad mindestens mehrere Zentimeter, mehr bevorzugt mindestens mehrere Dezimeter. Es kann dann ausreichend sein, wenn die Reichweite der Mikro-Verschiebeeinrichtung nur wenige Millimeter beträgt, sodass es möglich ist, für die Mikro-Verschiebeeinrichtung Aktuatoren wie z.B. Voice-Coil-Aktuatoren zu verwenden, die lediglich eine derartige Reichweite aufweisen.

Erfindungsgemäss wird die Position des Objektträgers direkt in Bezug auf ein relativ zum Basiselement ortsfestes Referenzsystem bestimmt. Das zum Basiselement ortsfeste Referenzsystem stellt dabei einen Bestandteil einer Encoder-Einrichtung dar, wobei die Encoder-Einrichtung einen Encoder-Massstab und eine Messeinrichtung zum Auslesen, d.h. zum messtechnischen Erfassen des Encoder-Massstabs umfasst. Dadurch, dass entweder der Encoder-Massstab oder die Messeinrichtung zum Basiselement ortsfest angeordnet ist, wird das zum Basiselement ortsfeste Referenzsystem festgelegt. Das Referenzsystem wird gemäss bevorzugten Ausführungsformen der Erfindung durch einen ortsfesten Encoder-Massstab festgelegt, wobei es sich bei dem Encoder-Massstab um eine räumliche Anordnung von Gitterlinien, Streifenmusterlinien, Punkten oder anderen Strukturen, deren Erfassung zu Positionsbestimmung geeignet ist, handeln kann. Bevorzugt handelt es sich dabei um eine zweidimensionale Anordnung, insbesondere um ein zweidimensionales Gitter.

Das bedeutet, die erfindungsgemässe Positioniervorrichtung umfasst bevorzugt als Referenz einen Encoder-Massstab, welcher gemäss einer bevorzugten Ausführungsart zumindest während der Positionsbestimmung ortsfest relativ zum Basiselement angeordnet ist und somit ein relativ zum Basiselement ortsfestes Referenzsystem darstellt. Ferner ist eine Messeinrichtung vorgesehen, welche zur Bestimmung der Absolutposition des Objektträgers den Massstab messtechnisch erfasst und welche zumindest während der Positionsbestimmung ortsfest relativ zum Objektträger angeordnet ist.

In einer anderen Ausführungsart ist der Encoder-Massstab nicht relativ zum Basiselement, sondern relativ zum Objektträger ortsfest angeordnet. Der Encoder-Massstab könnte beispielsweise fest mit dem Objektträger, insbesondere mit dessen Unterseite, verbunden sein. Gemäss dieser Ausführungsart ist die Messeinrichtung zumindest während der messtechnischen Erfassung des Encoder-Massstabs ortsfest relativ zum Basiselement angeordnet. Auf diese Weise wird ein zum Basiselement ortsfestes Referenzsystem festgelegt.

Im Unterschied dazu würde bei einer interferometrischen Messung mittels eines Interferometers, welcher keinen verkörperten Massstab umfasst, die Absolutposition nicht direkt in Bezug auf ein relativ zum Basiselement ortsfestes Referenzsystem bestimmt, da mittels eines Interferometers aus einem Interferenzmuster auf eine Position rückgeschlossen wird, sodass die Position lediglich indirekt bestimmt wird. Eine interferometrische Messeinrichtung umfasst kein ortsfestes Referenzsystem. Die indirekte interferometrische Messung ist, wie weiter oben beschrieben ist, fehleranfällig.

Es ist im Rahmen der Erfindung möglich aber nicht zwingend erforderlich, dass die Bewegung der Mikro-Verschiebeeinrichtung mit höherer Ortsauflösung als die Bewegung der Makro-Verschiebeeinrichtung erfolgt, sodass die Mikro-Verschiebeeinrichtung geeignet ist, eine Positionierung des Objektträgers vorzunehmen, die genauer ist als die Ortauflösung der Makro-Verschiebeeinrichtung, wodurch die Regelung der Bewegung der Makro-Verschiebeinrichtung mit geringerem Rechenaufwand möglich ist und/oder die Bewegung der Makro-Verschiebeinrichtung mit geringerem apparativem Aufwand umgesetzt werden kann.

Gemäss der Erfindung ist es bevorzugt, dass die Steuereinrichtung dazu ausgebildet ist, die Position des Objektträgers in den wenigstens zwei Freiheitsgraden mittels der Mikro-Verschiebeinrichtung direkt in Bezug auf das relativ zum Basiselement ortsfeste Referenzsystem zu regeln. Dadurch wird, insbesondere bei langen Verfahrwegen, ein schnelles und präzises Positionieren des Objektträgers ermöglicht. Beispielsweise kann durch die Verwendung einer Absolutposition des Objektträgers zum Regeln der Position des Objektträgers der Rechenaufwand der Steuereinrichtung geringer sein, als wenn eine der Regelung eine Position der Makro-Verschiebeeinrichtung sowie eine Relativposition des Objektträgers relativ zur Makro-Verschiebeeinrichtung zugrunde liegt.

Gemäss einer bevorzugten Ausführungsform der Erfindung weist die Makro-Verschiebeeinrichtung einen in wenigstens den zwei Freiheitsgraden bewegbaren Rahmen mit einer Rahmenöffnung auf. Der Rahmen stellt das bewegte System der Makro-Verschiebeeinrichtung oder einen Teil davon dar. Der Objektträger ist innerhalb der Rahmenöffnung mittels der Mikro-Verschiebeeinrichtung in wenigstens den zwei Freiheitsgraden relativ zum Basiselement positionierbar. Dies ist gleichbedeutend damit, dass der Rahmen als das bewegte System der Makro-Verschiebeeinrichtung oder als Teil davon so positionierbar ist, dass der Rahmen den Objektträger umgibt.

Rahmen und Objektträger können dabei so angeordnet sein, dass der Objektträger eine im Wesentlichen mittige Position in der Rahmenöffnung einnimmt. Der Objektträger kann innerhalb der Rahmenöffnung je nach Reichweite der Mikro-Verschiebeeinrichtung auch andere Positionen, die von der Steuereinrichtung vorgegeben und geregelt werden können, einnehmen. Vorteilhaft ist es dabei, wenn der Objektträger nicht zu nahe am Rand der Rahmenöffnung positioniert ist, sodass für die Mikro-Verschiebeeinrichtung Spielraum für die Bewegung in alle Richtungen besteht.

Um eine hochpräzise Positionierbarkeit, insbesondere im Mikrometer- oder sogar Submikrometer-Bereich zu erreichen, kann nach einer vorteilhaften Ausgestaltung der Erfindung die Mikro-Verschiebeeinrichtung zum Erzeugen einer entsprechenden Mikro-Verschiebebewegung entlang wenigstens einer ersten Mikro-Achse und einer zweiten Mikro-Achse eine wenigstens zweiachsige elektrodynamische Verschiebeeinrichtung, insbesondere eine Voice-Coil-Verschiebeeinrichtung umfassen. Voice-Coil-Verschiebeeinrichtungen, die alternativ auch als Schwingspulen- oder Tauchspulen-Aktuator-Einrichtungen bekannt sind, sind zweipolige Dreh- und/oder Translations-Antriebsmechanismen mit üblicherweise limitierten Weg- und/oder Winkelverstellbereichen. Sie zeichnen sich durch eine hohe Wiederhol- und Positioniergenauigkeit aus und sind in vorteilhafter Weise frei von Hysterese. Voice-Coil-Aktuatoren umfassen zwei Komponenten: eine Magneteinrichtung, etwa eine Permanentmagnet-Einrichtung, und eine elektromagnetische Spuleneinrichtung bzw. Spule, die auf einen nicht-magnetischen Spulenkörper gewickelt ist, wobei eine der beiden Komponenten im ruhenden System und die jeweils andere Komponente im bewegten System der Verschiebeeinrichtung angeordnet ist, um die Bewegung entlang des Kraftvektors bzw. Drehmomentvektors zu ermöglichen. Nach einer bevorzugten Ausgestaltung der Erfindung ist es vorgesehen, dass die jeweiligen Spuleneinrichtungen im bewegten System der Makro-Verschiebeeinrichtung und die jeweilige Magneteinrichtungen im bewegten System der Mikro-Verschiebeeinrichtung angeordnet sind. Fliesst ein Strom durch die Spuleneinrichtung, so wird eine Kraft bzw. ein Drehmoment generiert. Richtung und Amplitude werden dabei von der Stromstärke und der Stromrichtung bestimmt. Durch geeignete Wahl dieser Parameter lassen sich mit Voice-Coil-Aktuatoranordnungen - wie weiter unten näher erläutert wird - nicht nur rein lineare Translationsbewegungen, sondern auch kombinierte Translations-Rotationsbewegungen realisieren.

Gemäss einer besonders vorteilhaften Ausgestaltung der Erfindung kann es vorgesehen sein, dass die wenigstens zweiachsige Voice-Coil-Verschiebeeinrichtung für die erste und/oder die zweite Mikro-Achse jeweils wenigstens ein Paar Voice-Coil-Aktuatoren mit jeweils wenigstens einer Spuleneinrichtung und wenigstens einer Magneteinrichtung, etwa einer Permanentmagnet-Einrichtung, aufweist. Vorzugsweise sind die jeweiligen Voice-Coil-Aktuatoren eines Paares bezüglich der jeweiligen Mikro-Achse an gegenüberliegenden Seiten des Objektträgers angeordnet. So kann etwa bei einem rechteckförmigen Objektträger eine zweiachsige orthogonale Voice-Coil-Verschiebeeinrichtung dadurch realisiert werden, dass an den vier Seiten des Objektträgers jeweils wenigstens ein Voice-Coil-Aktuator angeordnet ist, wobei die Aktuatoren an sich gegenüberliegenden Seiten des rechteckförmigen Objektträgers jeweils ein Paar zur Erzeugung einer entsprechenden Mikro-Verschiebebewegung entlang einer der zwei Achsen bilden. Von Vorteil sind an jeder Seite sogar zwei oder mehr Voice-Coil-Aktuatoren angeordnet. So sind etwa bei einer Vorrichtung mit jeweils korrespondierenden Paaren von Voice-Coil-Aktuatoren für eine Achse von Vorteil zwei Paare von Voice-Coil-Aktuatoren an jeweils gegenüberliegenden Seiten bezüglich der jeweiligen Mikro-Achse vorhanden.

Es ist im Rahmen der Erfindung beispielsweise auch möglich, dass die Voice-Coil-Verschiebeeinrichtung lediglich für eine der Mikro-Achsen wenigstens ein Paar Voice-Coil-Aktuatoren mit jeweils wenigstens einer Spuleneinrichtung und wenigstens einer Magneteinrichtung aufweist, während sie für die andere(n) Mikro-Achsen jeweils eine ungepaarten Voice-Coil-Aktuator mit einer Spuleneinrichtung und einer Magneteinrichtung aufweist.

Es ist im Rahmen der Erfindung möglich, dass bezüglich mindestens einer der Mikro-Achsen ein oder mehrere Paare von Voice-Coil-Aktuatoren so an gegenüberliegenden Seiten des Objektträgers angeordnet sind, dass damit ein Drehmoment erzeugt werden kann, um eine Drehung des Objektträgers auszulösen. Bevorzugt steht die Achse, um die diese Drehung erfolgen kann, normal auf die beiden Mikro-Achsen. Dies lässt sich beispielsweise dadurch realisieren, dass die Spulen eines Paares von Voice-Coil-Aktuatoren nicht parallel geschaltet sind, sondern individuell ansteuerbar sind. Ferner können die Voice-Coil-Aktuatoren des Paars versetzt, d.h. schräg vis-àvis, an den einander gegenüberliegenden Seiten des Objektträgers angeordnet sein.

Bevorzugt verlaufen die erste und die zweite Mikro-Achse der Mikro-Verschiebeeinrichtung parallel zur ersten bzw. zweiten Makro-Achse der Makro-Verschiebeeinrichtung. Grundsätzlich ist es aber auch denkbar, dass die erste und/oder die zweite Mikro-Achse der Mikro-Verschiebeeinrichtung nicht parallel zur ersten bzw. zweiten Makro-Achse der Makro-Verschiebeeinrichtung verläuft.

Bevorzugt sind die Makro-Verschiebeeinrichtung und der Objektträger über die Mikro-Verschiebeeinrichtung miteinander gekoppelt, wobei es sich weiter bevorzugt um eine berührungsfreie Kopplung, insbesondere um eine magnetische Lagerung handelt. In anderen Worten stützt sich die Mikro-Verschiebeeinrichtung an der Makro-Verschiebeeinrichtung ab, ohne mit dieser physisch verbunden zu sein. Eine berührungsfreie magnetische Lagerung kann beispielsweise mittels der Voice-Coil-Aktuatoren in den oben beschriebenen Konfigurationen erreicht werden. Der Begriff "berührungsfrei" ist synonym zum Begriff "kontaktfrei" zu verstehen. Bei einer berührungsfreien Lagerung berührt das gelagerte Bauteil kein als Lager fungierendes Bauteil, sondern wird beispielsweise durch magnetische Levitation oder auf einem Fluidfilm oder Fluidkissen gehalten.

Nach einer vorteilhaften Ausgestaltung der Erfindung weist die Positionsbestimmungs-Einrichtung eine Encoder-Einrichtung auf, welche insbesondere einen relativ zum Basiselement ortsfest angeordneten Encoder-Massstab für die Mikro-Verschiebeeinrichtung, d.h. für die Bestimmung der Absolutposition des Objektträgers, umfasst. Die Encoder-Einrichtung umfasst weiter eine insbesondere im bewegten System der Mikro-Verschiebeeinrichtung angeordnete Mikro-Messeinrichtung zum Auslesen des Encoder-Massstabs und zum Erzeugen eines der Absolutposition des bewegten Systems der Mikro-Verschiebeeinrichtung entsprechenden Mikro-Positionssignals.

Encoder-Einrichtungen zur Positionsbestimmung sind aus dem Stand der Technik beispielsweise als sogenannte "Absolutencoder" oder "Inkrementalencoder" grundsätzlich bekannt und werden in der Handhabungs- und Automatisierungstechnik sowie an Mess- und Prüfeinrichtungen als Längen- oder Winkelmessgeräte eingesetzt. Ein Absolutencoder ist eine Encoder-Einrichtung, welche keine Referenzfahrt (sogenanntes "Homing") durchführen muss und jederzeit im Betrieb ein reproduzierbares Positionssignal erzeugt. Im Gegensatz müssen Inkrementalencoder mittels einer wiederholbaren Position (Indexmarke, "Homeswitch" oder ähnlichem) referenziert werden, d.h. es ist eine Referenzfahrt zu dieser Position erforderlich, bevor ein reproduzierbares Positionssignal erzeugt werden kann. Absolutencoder haben demnach den besonderen Vorteil, dass der absolute Positionsmesswert ohne Referenzieren unmittelbar nach Inbetriebnahme der Einrichtung zur Verfügung steht. Der Vorteil, auf die Vornahme fehleranfälliger interferometrischer Messungen verzichten zu können, lässt sich auch mittels Inkrementalencodern realisieren.

Grundsätzlich sind verschiedene Wirk- bzw. Messmechanismen denkbar, auf denen die Encoder-Einrichtung basieren kann. So kann die Encoder-Einrichtung gemäss verschiedener Ausgestaltungen der vorliegenden Erfindung eine optische, magnetische, kapazitive oder induktive Encoder-Einrichtung sein.

Es ist im Rahmen der Erfindung bevorzugt, aber nicht zwingend, dass der Encoder-Massstab für die Mikro-Verschiebeeinrichtung relativ zum Basiselement ortsfest angeordnet ist.

Für die erfindungsgemässe Positionierung innerhalb der Ebene in wenigstens zwei, vorzugsweise drei Freiheitsgraden ist es nach einer besonders vorteilhaften Ausgestaltung der Erfindung vorgesehen, dass der Encoder-Massstab ein parallel zur Ebene und relativ zum Basiselement ortsfest angeordnetes Referenzgitter oder Referenzstreifenmuster aufweist. Vorteilhafterweise ist der Encoder-Massstab bzw. das Referenzgitter oder Referenzstreifenmuster auf der Oberfläche des Basiselementes angeordnet, die dem Objektträger zugewandt ist. Beispielsweise durch die Verwendung eines Referenzgitters werden auch in vorteilhafter Weise die bei der aus dem Stand der Technik bekannten Positionsmessung per Laserinterferometer auftretenden, durch Turbulenzen bzw. Dichteschwankungen des umgebenden Mediums (Luft) bedingten Messfehlern vermieden. Anstelle eines Referenzgitters oder Referenzstreifenmusters kann auch ein Referenzmuster mit einer einem anderen Codierungsmuster wie z.B. ein Punktmuster oder ein Muster, in welchem verschiedene Codierungsmuster miteinander kombiniert sind, verwendet werden. Im bewegten System der Mikro-Verschiebeeinrichtung ist gemäss dieser Ausgestaltung eine Mikro-Messeinrichtung zum Auslesen des Encoder-Massstabs angeordnet.

Encoder-Massstab und Mikro-Messeinrichtung sind Bestandteile der Encoder-Einrichtung.

Es kann aber auch vorteilhaft sein, wenn der Encoder-Massstab für die Bestimmung der Absolutposition des Objektträgers im bewegten System der Mikro-Verschiebeeinrichtung angeordnet ist. Dies lässt sich beispielsweise dadurch realisieren, dass der Encoder-Massstab mit dem Objektträger, insbesondere mit dessen Unterseite, verbunden ist. In diesem Fall weist die Encoder-Einrichtung eine Mikro-Messeinrichtung auf, welche zumindest während der Positionsbestimmung relativ zum Basiselement ortsfest angeordnet ist.

Im Rahmen der Erfindung ist es ferner möglich, mindestens einen Makro-Encoder-Massstab im einem bewegten System der Makro-Verschiebeeinrichtung anzuordnen und den mindestens einen Makro-Encoder-Massstab mittels mindestens einer relativ zum Basiselement ortsfest angeordneten Makro-Messeinrichtung auszulesen, um so die Absolutposition des bewegten Systems der Makro-Verschiebeeinrichtung zu bestimmen. Massstab und Makro-Messeinrichtung bilden eine Encoder-Einrichtung für die Makro-Verschiebeeinrichtung. Beispielsweise können zwei derartige Makro-Encoder-Einrichtungen vorhanden sein, welche zur Bestimmung der Absolutposition des bewegten Systems der Makro-Verschiebeeinrichtung in Bezug auf jeweils einen Freiheitsgrad dienen. Auf diese Weise kann mittels zweier eindimensionaler Encoder-Einrichtungen eine Absolutposition in zwei Dimensionen bestimmt werden.

Gemäss einer bevorzugten Ausführungsform der Erfindung ist es vorgesehen, dass die Positionsbestimmungs-Einrichtung dazu eingerichtet ist, sowohl die Absolutposition eines bewegten Systems der Makro-Verschiebeeinrichtung als auch die Absolutposition eines bewegten Systems der Mikro-Verschiebeeinrichtung in wenigstens zwei Freiheitsgraden jeweils direkt in Bezug auf ein relativ zum Basiselement ortsfestes Referenzsystem zu bestimmen. Mehr bevorzugt wird dabei für die Absolutpositionen ein gemeinsames Referenzsystem verwendet.

Auf diese Weise wird auch die Position des bewegten Systems der Makro-Verschiebeeinrichtung nicht durch eine Addition der Position bewegten Systems der Mikro-Verschiebeeinrichtung, d.h. der Position des Objektträgers, und der Relativposition zwischen Makro-Verschiebeeinrichtung und Mikro-Verschiebeeinrichtung bestimmt.

In erfindungsgemässer Weise wurde erkannt, dass die Positionierungspräzision und -stabilität der gesamten Vorrichtung im Vergleich zum Stand der Technik deutlich gesteigert werden kann, indem die Bestimmung und regelungstechnische Verwendung der Relativposition zwischen Makro- und Mikro-Verschiebeeinrichtung durch die Bestimmung und Verwendung der jeweiligen Absolutposition beider Verschiebeeinrichtungen relativ zu zumindest einem, bevorzugt gemeinsamen Referenzsystem ersetzt wird. Insbesondere wird dadurch eine unabhängige, nicht relative Regelung von Makro- und Mikro-Verschiebeeinrichtung ermöglicht. Insoweit ist es nach einer vorteilhaften Ausgestaltung der Erfindung vorgesehen, dass die Steuereinrichtung dazu ausgebildet ist, unabhängig voneinander die Position des bewegten Systems der Makro- und der Mikro-Verschiebeeinrichtung in wenigstens zwei Freiheitsgraden jeweils direkt in Bezug auf das gemeinsame Referenzsystem zu regeln. Dabei ist es möglich, dass die Position des bewegten Systems der Makro-Verschiebeeinrichtung und die Position der Mikro-Verschiebeeinrichtung in Bezug auf dieselbe Regelsollposition geregelt werden, wobei der Regelung der Position des bewegten Systems der Makro-Verschiebeeinrichtung eine andere Regelschleife zugrunde liegt als der Regelung der Position des bewegten Systems der Mikro-Verschiebeeinrichtung.

Nach einer besonders vorteilhaften Ausgestaltung der Erfindung ist es vorgesehen, dass die Positionsbestimmungs-Einrichtung eine kombinierte Encoder-Einrichtung aufweist, die einerseits einen gemeinsamen, insbesondere relativ zum Basiselement ortsfest angeordneten Encoder-Massstab als gemeinsames Referenzsystem und andererseits wenigstens eine im bewegten System der Makro-Verschiebeeinrichtung angeordnete Makro-Messeinrichtung sowie wenigstens eine im bewegten System der Mikro-Verschiebeeinrichtung angeordnete Mikro-Messeinrichtung umfasst. Dabei sind die Makro- bzw. Mikro-Messeinrichtung jeweils dazu ausgebildet, den gemeinsamen Encoder-Massstab auszulesen und ein der Position des bewegten Systems der Makro- bzw. Mikro-Verschiebeeinrichtung entsprechendes Makro- bzw. Mikro-Positionssignal zu erzeugen, das im Weiteren von der Steuereinrichtung zur unabhängigen Regelung der Position der beiden Verschiebeeinrichtungen genutzt wird. Es ist möglich aber nicht zwingend erforderlich, dass die Genauigkeit der Mikro-Messeinrichtung höher ist als die Genauigkeit der Makro-Messeinrichtung.

Alternativ kann es vorgesehen sein, dass die Positionsbestimmungs-Einrichtung für die Makro- und die Mikro-Verschiebeeinrichtung anstelle einer kombinierten Encoder-Einrichtung jeweils wenigstens eine Makro- und eine Mikro-Encoder-Einrichtung aufweist, umfassend jeweils wenigstens einen insbesondere relativ zum Basiselement ortsfest angeordneten Makro- bzw. Mikro-Encoder-Massstab sowie jeweils wenigstens eine im bewegten System der Makro- bzw. Mikro-Verschiebeeinrichtung angeordnete Makro- bzw. Mikro-Messeinrichtung zum Auslesen des Makro- bzw. Mikro-Encoder-Massstabs und zum Erzeugen eines der Absolutposition des bewegten Systems der Makro- bzw. Mikro-Verschiebeeinrichtung entsprechenden Makro- bzw. Mikro-Positionssignals.

Für die Bestimmung und Regelung der Position kann es ausreichen, dass die Makro-Encoder-Einrichtung gestuft aufgebaut ist. So kann es nach einer weiteren vorteilhaften Ausgestaltung der Erfindung vorgesehen sein, dass bei Positioniervorrichtung mit einer Makro-Verschiebeeinrichtung, die eine erste und zweite Verschiebeeinrichtung zum Erzeugen einer Makro-Verschiebebewegung entlang einer ersten und einer zweiten Makro-Achse aufweist, wobei die erste Verschiebeeinrichtung im bewegten System der zweiten Verschiebeeinrichtung angeordnet ist, eine Positionsbestimmungs-Einrichtung aufweist, die folgendes umfasst:
- wenigstens eine erste Makro-Encoder-Einrichtung mit wenigstens einem ersten Makro-Encoder-Massstab im bewegten System der zweiten Verschiebeeinrichtung und wenigstens einer im bewegten System der ersten Verschiebeeinrichtung angeordneten ersten Makro-Messeinrichtung zum Auslesen des ersten Makro-Encoder-Massstabs und zum Erzeugen eines der Absolutposition des bewegten Systems der ersten Verschiebeeinrichtung entsprechenden ersten Makro-Positionssignals entlang der ersten Makro-Achse,
- wenigstens eine zweie Makro-Encoder-Einrichtung mit wenigstens einem, insbesondere relativ zum Basiselement ortsfest angeordneten zweiten Makro-Encoder-Massstab und wenigstens einer im bewegten System der zweiten Verschiebeeinrichtung angeordneten zweiten Makro-Messeinrichtung zum Auslesen des zweiten Makro-Encoder-Massstabs und zum Erzeugen eines der Absolutposition des bewegten Systems der zweiten Verschiebeeinrichtung entsprechenden zweiten Makro-Positionssignals entlang der zweiten Makro-Achse, und
- wenigstens eine Mikro-Encoder-Einrichtung mit wenigstens einem insbesondere relativ zum Basiselement ortsfest angeordneten Mikro-Encoder-Massstab sowie wenigstens einer im bewegten System der Mikro-Verschiebeeinrichtung angeordneten Mikro-Messeinrichtung zum Auslesen des Mikro-Encoder-Massstabs und zum Erzeugen eines der Absolutposition des bewegten Systems der Mikro-Verschiebeeinrichtung entsprechenden Mikro-Positionssignals.

Für die erfindungsgemässe Positionierung innerhalb der Ebene in wenigstens zwei, vorzugsweise drei Freiheitsgraden ist es nach einer weiteren vorteilhaften Ausgestaltung der Erfindung vorgesehen, dass der gemeinsame Encoder-Massstab ein parallel zur Ebene und relativ zum Basiselement ortsfest angeordnetes Referenzgitter oder Referenzstreifenmuster aufweist. Von Vorteil ist der Encoder-Massstab bzw. das Referenzgitter auf der Oberfläche des Basiselementes angeordnet, die dem Objektträger zugewandt ist. Durch die Verwendung eines Referenzgitters werden auch in vorteilhafter Weise die bei der aus dem Stand der Technik bekannten Positionsmessung per Laserinterferometer auftretenden, durch Turbulenzen bzw. Dichteschwankungen des umgebenden Mediums (Luft) bedingten Messfehlern vermieden. Anstelle eines Referenzgitters oder Referenzstreifenmusters kann auch ein Referenzmuster mit einer einem anderen Codierungsmuster wie z.B. ein Punktmuster oder ein Muster, in welchem verschiedene Codierungsmuster miteinander kombiniert sind, verwendet werden.

Analog können der Makro-Encoder-Massstab und/oder der Mikro-Encoder-Massstab ein parallel zur Ebene und relativ zum Basiselement ortsfest angeordnetes Referenzgitter oder Referenzstreifenmuster aufweisen. Entsprechend kann es bei den eindimensionalen Massstäben vorgesehen sein, dass der erste Makro-Encoder-Massstab und/oder der zweite Makro-Encoder-Massstab ein Referenzgitter oder Referenzstreifenmuster aufweisen.

Nach einer weiteren Ausgestaltung der Erfindung kann es vorgesehen sein, dass sich der Encoder-Massstab bzw. das Referenzgitter oder Referenzstreifenmuster wenigstens über einen gemeinsamen maximalen Verschiebebereich der Makro- und Mikro-Verschiebeeinrichtung erstreckt. Damit ist gewährleistet, dass die Mess- und Regelungsgenauigkeit über den gesamten gemeinsamen maximalen Verschiebebereich der Positioniervorrichtung zur Verfügung steht. Referenzgitter lassen sich insbesondere problemlos skalieren, so dass auf über einen grossen Verfahr- bzw. Verschiebbarkeitsbereich stets eine hinreichend grosse Positioniergenauigkeit gewährleistet werden kann. Entsprechend kann es vorgesehen sein, dass sich der erste Makro-Encoder-Massstab und/oder der zweite Makro-Encoder-Massstab über einen maximalen Verschiebebereich der ersten bzw. zweiten Verschiebeeinrichtung entlang der ersten bzw. zweiten Makro-Achse erstrecken.

Handelt es sich bei der Encoder-Einrichtung um eine optische Encoder-Einrichtung, so kann es nach einer vorteilhaften Ausgestaltung der Erfindung vorgesehen sein, dass das Referenzgitter ein optisches Beugungsgitter oder ein optisches Reflexionsgitter aufweist. Im Falle einer magnetisch oder induktiv arbeitenden Encoder-Einrichtung, kann das Referenzgitter nach einer alternativen Ausgestaltung der Erfindung eine zweidimensional periodisch variierende Magnetisierungsstruktur aufweisen. Analog kann es vorgesehen sein, dass das Referenzstreifenmuster ein optisches Beugungsstreifenmuster oder ein optisches Reflexionsstreifenmuster oder eine eindimensional periodisch variierende Magnetisierungsstruktur aufweist.

Eine vorteilhafte Ausgestaltung der Makro-Verschiebeeinrichtung umfasst wenigstens eine zweiachsige Linearführungs-Verschiebeeinrichtung zur Erzeugung einer jeweiligen Makro-Verschiebebewegung entlang wenigstens einer ersten Makro-Achse und einer zweiten Makro-Achse, die parallel zur Verschiebeebene und vorzugsweise orthogonal zueinander ausgerichtet sind. Insbesondere kann es sich bei der zweiachsigen Linearführungs-Verschiebeeinrichtung um eine zweiachsige Kreuztisch-Verschiebeeinrichtung oder alternativ um eine Gantry-Verschiebeeinrichtung entlang der zweiten Makro-Achse und eine darauf angeordnete wenigstens einachsige Linearführungs-Verschiebeeinrichtung entlang der ersten Makro-Achse handeln. Denkbar ist auch, dass die wenigstens zweiachsige Linearführungs-Verschiebeeinrichtung eine zweiachsige Doppelgantry-Verschiebeeinrichtung umfasst.

Unabhängig davon, ob die zweiachsige Linearführungs-Verschiebeeinrichtung eine zweiachsige Kreuztisch-Verschiebeeinrichtung, eine Gantry-Verschiebeeinrichtung entlang der zweiten Makro-Achse in Kombination mit einer darauf angeordneten einachsigen Linearführungs-Verschiebeeinrichtung entlang der ersten Makro-Achse, eine zweiachsige Doppelgantry-Verschiebeeinrichtung oder eine andere zweiachsige Verschiebeeinrichtung umfasst, ist es bevorzugt aber nicht zwingend vorgesehen, dass die Positionsbestimmungs-Einrichtung ein gemeinsames Referenzsystem, insbesondere einen gemeinsamen Encoder-Massstab für die Bestimmung der Absolutpositionen der bewegten Systeme der Mikro- und der Makro-Verschiebeeinrichtung verwendet. Dabei kann es sich bei dem gemeinsamen Encoder-Massstab beispielsweise um ein zweidimensionales Gittermuster handeln. Denkbar ist aber auch, dass kein gemeinsamer Encoder-Massstab vorhanden ist, sondern die Absolutpositionen relativ zu verschiedenen Encoder-Massstäben bestimmt werden.

Zum Erzeugen der Makro-Verschiebebewegung entlang der ersten und/oder der zweiten Makro-Achse kann die Makro-Verschiebeeinrichtung nach einer weiteren vorteilhaften Ausgestaltung der Erfindung jeweils wenigstens einen Linearmotorantrieb aufweisen. Denkbar sind aber auch andere Antriebsmechanismen, beispielsweise Servomotorantriebe, Spindelantriebe, Riemenantriebe, Kettenantriebe, Pneumatikantriebe, Hydraulikantriebe oder dergleichen.

Denkbar ist auch, dass die Mikro-Verschiebeeinrichtung nicht wie weiter oben beschrieben zwei orthogonale Mikro-Achsen aufweist, sondern auch zwei oder mehrere nicht-orthogonale Achsen. So kann es vorgesehen sein, dass der Objektträger parallel zur Verschiebeebene die Grundfläche eines insbesondere gleichseitigen Dreiecks aufweist, an dessen Seiten jeweils wenigstens ein Voice-Coil-Aktuator angeordnet ist, wobei die drei Seiten jeweils eine Mikroachse definieren. Alternativ kann es vorgesehen sein, dass der Objektträger eine kreisförmige Grundfläche parallel zur Verschiebeebene aufweist, um deren Umfang wenigstens drei Voice-Coil-Aktuatoren rotationssymmetrisch bezüglich einer Achse senkrecht zur Objektträger-Ebene bzw. Verschiebeebene angeordnet sind. Denkbar ist auch, dass mehr als drei, insbesondere vier oder fünf Voice-Coil-Aktuatoren rotationssymmetrisch am Umfang verteilt angeordnet sind.

Mit einer derartigen Anordnung lassen sich neben den LinearAchsen innerhalb der Ebene auch Positionierungen in einem dritten Freiheitsgrad, nämlich um eine Drehachse senkrecht zur Regelungsebene realisieren. Eine solche Regelung um einen dritten Freiheitsgrad ist aber auch mit der oben beschriebenen zweiachsigen Voice-Coil-Verschiebeeinrichtung möglich, etwa dann, wenn die jeweiligen Voice-Coil-Aktuatoren eines Paares bezüglich einer der Mikro-Achse gegenläufig betrieben werden.

Entsprechend ist es gemäss einer weiteren vorteilhaften Ausgestaltung der Erfindung vorgesehen, dass die Mikro-Verschiebeeinrichtung ganz allgemein zum Erzeugen einer Mikro-Verschiebebewegung in wenigstens drei, insbesondere in genau drei Freiheitsgraden ausgebildet ist. Entsprechend ist auch die Positionsbestimmungs-Einrichtung in vorteilhafter Weise dazu ausgebildet, die Position des bewegten Systems der Mikro-Verschiebeeinrichtung in Bezug auf die gemeinsame Referenz in Form des gemeinsamen Referenzsystems, insbesondere in Form eines gemeinsamen Encoder-Massstabs in drei Freiheitsgraden zu bestimmen. Mit einem Referenzgitter und einer entsprechenden Messeinrichtung ist dies technisch sehr einfach realisierbar. Entsprechend ist es weiterhin von Vorteil, wenn auch die Steuereinrichtung dazu ausgebildet ist, die Position des bewegten Systems der Mikro-Verschiebeeinrichtung in drei Freiheitsgraden in Bezug auf die gemeinsame Referenz zu regeln.

Nach einer weiteren vorteilhaften Ausgestaltung der Erfindung kann es zudem vorgesehen sein, dass der Objektträger auf dem Basiselement mittels eines Fluidfilms gelagert ist. Insbesondere ist denkbar, dass die fluidfilmbasierte Lagerung mittels wenigstens einer Fluidfilm-Lagerungseinrichtung realisiert ist, wobei die Fluidfilm-Lagerungseinrichtung vorzugsweise auf einer dem Basiselement zugewandten Seite des Objektträgers angeordnet ist. Um die Steifigkeit und Stabilität des gesamten Systems zu erhöhen, kann es ferner vorgesehen sein, dass die Fluidfilm-Lagerungseinrichtung eine integrierte Vakuum- oder Magnetvorspannungseinrichtung aufweist. In Kombination mit einem Voice-Coil-Antrieb lässt sich mit Hilfe der Fluidfilm-Lagerungseinrichtung eine Positioniervorrichtung realisieren, die einen berührungslosen Antrieb und eine entsprechend berührungslose Lagerung aufweist. Zusätzlich kann es vorgesehen sein, dass das Basiselement auf einem Dämpfungssystem gelagert ist.

Durch einen Fluidfilm ist eine im Wesentlichen kontaktfreie Lagerung des Objektträgers möglich. Alternativ oder zusätzlich zur Fluidfilmlagerung kann nach einer weiteren vorteilhaften Ausgestaltung der Erfindung eine andere berührungsfreie Lagerung, insbesondere eine berührungsfreie Magnetlagerung verwendet werden.

Die Erfindung betrifft im Weiteren eine Vorrichtung zum Prozessieren eines Werkstückes, insbesondere zum Bearbeiten, Belichten und/oder Inspizieren eines Wafers, die eine Prozessiereinheit zum Bearbeiten, Belichten und/oder Inspizieren des Werkstückes umfasst und zudem mit wenigstens einer erfindungsgemässen Positioniervorrichtung ausgestattet ist, um das Werkstück innerhalb einer Ebene in wenigstens zwei, vorzugsweise drei Freiheitsgraden relativ zur Prozessiereinheit geregelt zu positionieren.

Weitere Ziele, Vorteile und Anwendungsmöglichkeiten der vorliegenden Erfindung entnehmen sich aus den nachfolgenden Beschreibungen mehrerer Ausführungsbeispiele der Erfindung sowie anhand der beigefügten Figuren.

Es zeigen:
- Fig. 1: eine perspektivische Ansicht eines möglichen Ausführungsbeispiels der erfindungsgemässen Positioniervorrichtung;
- Fig. 2: eine schematische Schnittdarstellung zum Grundprinzip der Positioniervorrichtung gemäss Fig. 1;
- Fig. 3: eine schematische Ansichtsdarstellung zum Grundprinzip der Mikro-Verschiebeeinrichtung der Positioniervorrichtung gemäss Fig. 1;
- Fig. 4: eine schematische Darstellung zum Grundprinzip der Positioniervorrichtung gemäss Fig. 1; und
- Fig. 5: eine schematische Ansicht einer alternativen Ausführungsform der Mikro-Verschiebeeinrichtung.

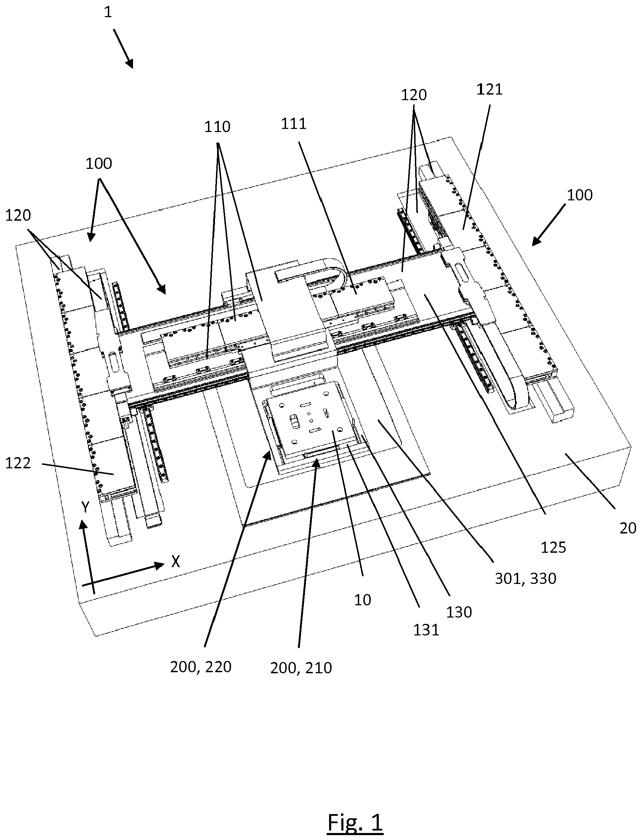

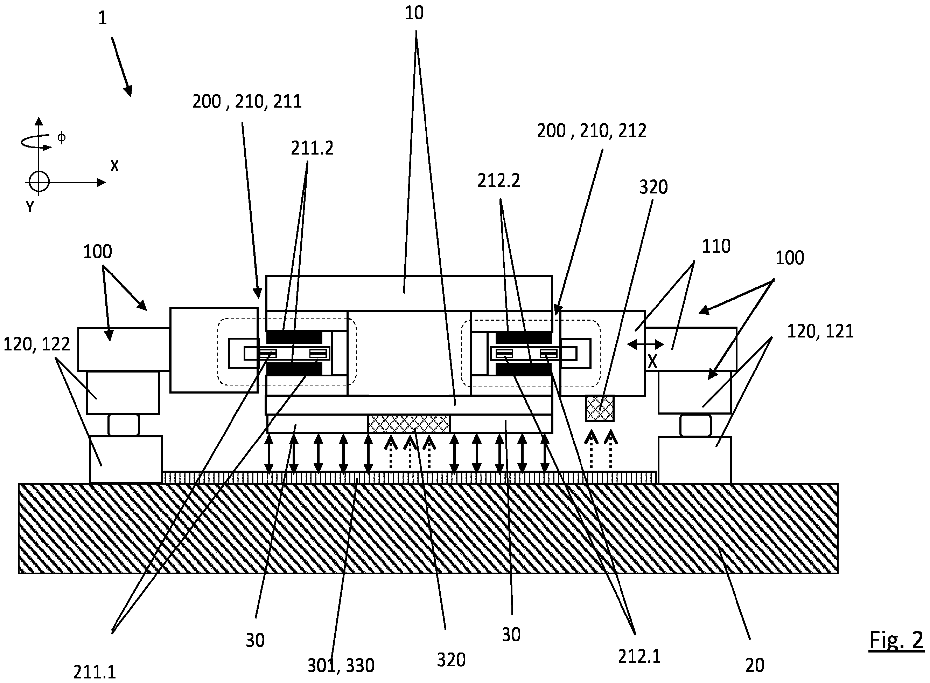

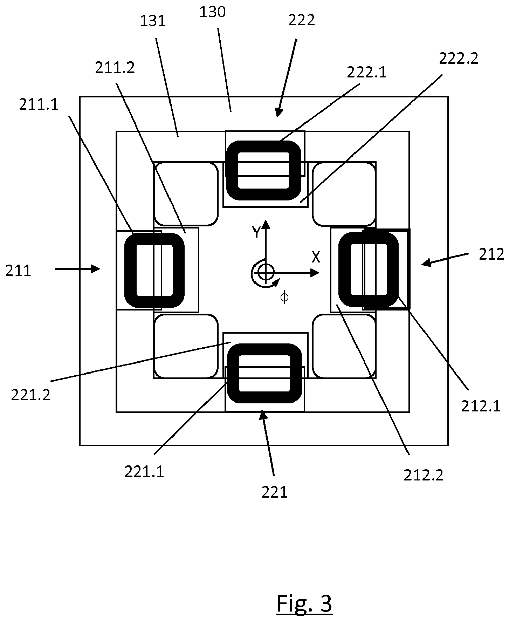

Die Fig. 1-4 zeigen ein mögliches Ausführungsbeispiel einer erfindungsgemässen Positioniervorrichtung 1, die zum präzisen Positionieren eines Objektes, etwa eines Wafers, innerhalb einer zweidimensionalen Ebene X-Y in wenigstens zwei, vorliegend drei Freiheitsgraden über grosse Verfahrwege verwendet werden kann. Das zu positionierende Objekt kann auf einen Objektträger 10 aufgenommen werden, der sich im bewegten System einer zweidimensionalen Mikro-Verschiebeeinrichtung 200 befindet. Die Mikro-Verschiebeeinrichtung 200 selbst ist im bewegten System einer zweidimensionalen Makro-Verschiebeeinrichtung 100 angeordnet, die wiederum auf einem Basiselement 20, etwa einem Dämpfungstisch, installiert ist.

Im vorliegend gezeigten Ausführungsbeispiel besteht die Makro-Verschiebeeinrichtung 100 aus einem zweiachsigen Linear-Führungssystem, mit der sich die Mikro-Verschiebeeinrichtung 200, der Objektträger 10 und damit das zu positionierende Objekt über lange Verfahrwege und mit hohen Geschwindigkeiten entlang einer ersten Makro-Achse X und einer dazu orthogonalen zweiten Makro-Achse Y parallel zur Ebene X-Y positionieren lässt. Zur Erzeugung der Makro-Verschiebebewegung entlang der zweiten Makro-Achse Y verfügt die Makro-Verschiebeeinrichtung über eine einachsige Gantry-Verschiebeeinrichtung 120, auf der Gantry-Brücke 125 zur Erzeugung der Makro-Verschiebebewegung entlang der ersten Makro-Achse X eine einachsige Linearführungseinrichtung 110 angeordnet ist. Sowohl die Gantry-Verschiebeeinrichtung 120 entlang der zweiten Makro-Achse Y als auch die einachsige Linearführungs-Verschiebeeinrichtung 110 entlang der ersten Makro-Achse X werden jeweils über Linearmotoren 111, 121 und 122 angetrieben. An der einachsigen Linearführungs-Verschiebeeinrichtung 110 der Makro-Verschiebeeinrichtung 100 ist ein über das Brückenelement 125 der Gantry-Verschiebeeinrichtung 120 auskragendes Rahmenelement 130 angeordnet, das die stationären Teile bzw. das stationäre System der Mikro-Verschiebeeinrichtung 200 aufnimmt.

Die Mikro-Verschiebeeinrichtung 200 weist im vorliegenden Ausführungsbeispiel eine zweidimensionale Voice-Coil-Verschiebeeinrichtung 210, 220 auf, die zur Erzeugung einer Mikro-Verschiebebewegung entlang einer ersten Mikro-Achse X und einer dazu orthogonalen zweiten Mikro-Achse Y über je ein Paar Voice-Coil-Aktuatoren 211, 212; 221, 222 pro Achse verfügt. Im vorliegenden Ausführungsbeispiel verlaufen die erste und die zweite Mikro-Achse X, Y der Mikro-Verschiebeeinrichtung 200 parallel zur ersten bzw. zweiten Makro-Achse X, Y der Makro-Verschiebeeinrichtung 100.

Die Voice-Coil-Aktuatoren 211, 212; 221, 222 eines Paares sind dabei bezüglich der jeweiligen Mikro-Achse X, Y an jeweils gegenüberliegenden Seiten des rechteckförmigen Objektträgers 10 angeordnet. Jeder der Voice-Coil-Aktuatoren 211, 212; 221, 222 weist eine elektromagnetische Spule 211.1, 212.1; 221.1, 222.1 und einen dazugehörigen Permanentmagneten 211.2, 212.2; 221.2, 222.2 auf. Die Spulen 211.1, 212.1; 221.1, 222.1 sind im bewegten System der Makro-Verschiebeeinrichtung 100, konkret an den Innenseiten der Rahmenöffnung 131 des Rahmenelementes 130 angeordnet. Die Spulen 211.1, 212.1; 221.1, 222.1 sind demnach im stationären System der Mikro-Verschiebeeinrichtung 200 angeordnet. Demgegenüber sind die Permanentmagneten 211.2, 212.2; 221.2, 222.2 im bewegten System der Mikro-Verschiebeeinrichtung 200 angeordnet, konkret jeweils an den sich gegenüberliegenden Seiten des Objektträgers 10.

Der Objektträger 10 wird mittels einer vorliegend nur schematisch dargestellten und auf seiner Unterseite angeordneten Fluidfilm-Lagerungseinrichtungen 30 auf dem Basiselement 20 schwebend gelagert. In Kombination mit den Voice-Coil-Aktuatoren 211, 212; 221, 222 ist somit ein berührungsloser Antrieb und eine berührungslose Lagerung des Objektträgers 10 relativ zum Basiselement 20 realisiert. Im vorliegenden Ausführungsbeispiel ist der luftkissengelagerte Objektträger 10 zusätzlich über eine Vakuum-Vorspanneinrichtung gegenüber dem Basiselement 20 vorgespannt. Im Ergebnis wirken sich aufgrund der Luftkissenlagerung und des berührungslosen Voice-Coil-Antriebs Störeinflüsse auf das Basiselement 20 und die Makro-Verschiebeeinrichtung 200 nicht auf die Positionsgenauigkeit der gesamten Positioniervorrichtung 1 aus, da kein mechanischer Kontakt zwischen dem Objektträger 10 und der Makro-Verschiebeeinrichtung 100 und dem Basiselement 20 besteht.

Kern der Erfindung bildet die Positionsbestimmungs-Einrichtung 300, welche gemäss dem gezeigten Ausführungsbeispiel dazu ausgebildet ist, die Absolutposition des bewegten Systems der Makro- und der Mikro-Verschiebeeinrichtung 100, 200 jeweils in Bezug auf eine gemeinsame, am Basiselement 20 angeordnetes Referenzsystem 301 zu bestimmen. Im vorliegenden Ausführungsbeispiel dient eine kombinierte optische Encoder-Einrichtung als Positionsbestimmungs-Einrichtung 300, die einen gemeinsamen, relativ zum Basiselement 20 ortsfest angeordneten Encoder-Massstab 330 als gemeinsames Referenzsystem 301 aufweist. Vorliegend besteht dieser gemeinsame Encoder-Massstab 330 aus einem optischen Beugungsgitter, das auf der Oberseite des Basiselements 20 angeordnet ist und sich über den maximalen gemeinsamen Verschiebebereich der Makro- und Mikro-Verschiebeeinrichtung 100, 200 erstreckt. Zum Auslesen des gemeinsamen Encoder-Massstabs 330 und zum Erzeugen eines der jeweiligen Absolutposition des bewegten Systems der Makro- bzw. Mikro-Verschiebeeinrichtung 100, 200 entsprechenden Makro- bzw. Mikro-Positionssignals ist jeweils eine Makro-Messeinrichtung 310 bzw. eine Mikro-Messeinrichtung 320 vorgesehen, die jeweils im bewegten System der Makro- bzw. Mikro-Verschiebeeinrichtung 100, 200 angeordnet sind.

Die Makro-Messeinrichtung 310, die Mikro-Messeinrichtung 320 und der Encoder-Massstab 330 sind Bestandteile der Positionsbestimmungs-Einrichtung 300.

Die Positioniervorrichtung 1 verfügt im Weiteren über eine hier nicht näher dargestellte Steuereinrichtung, die dazu ausgebildet ist, unabhängig voneinander die Absolutposition des bewegten Systems der Makro- und der Mikro-Verschiebeeinrichtung 100, 200 in wenigstens zwei Freiheitsgraden X, Y jeweils in direktem Bezug auf das gemeinsame Referenzsystem 301, vorliegend dem gemeinsamen Encoder-Massstab 330 zu regeln. Im Vergleich zu den aus dem Stand der Technik bisher bekannten Vorrichtungen mit Relativpositionsmessung wird die Präzision und Stabilität der Positionierung dadurch deutlich verbessert, dass einerseits die Absolutpositionen des bewegten Systems der Makro- und der Mikro-Verschiebeeinrichtung 100, 200 in jeweils wenigstens zwei Freiheitsgraden X, Y jeweils in Bezug auf ein gemeinsames Referenzsystem 301, 330 ermittelt und darauf basierend jeweils unabhängig voneinander geregelt werden.

Die Verwendung eines zweidimensionalen Referenzgitters parallel zur Ebene, in der das zu positionierende Objekt bewegt werden kann, erlaubt zudem die Messung der Position in einem dritten Freiheitsgrad, nämlich einer Drehung um eine Achse φ senkrecht zur Ebene. Die Verwendung der vorliegenden Voice-Coil-basierten Mikro-Verschiebeeinrichtung 100 erlaubt zudem auch eine Positionierung des Objektträgers 10 in diesen drei Freiheitsgraden, nämlich eine Verschiebung entlang der beiden orthogonalen Mikro-Achsen X, Y und einer Drehung um die Achse φ senkrecht zur Ebene, die von den beiden Mikro-Achsen X, Y aufgespannt wird. Die Verschiebung bzw. Positionierung um die Drehachse φ lässt sich dadurch realisieren, dass die beiden Voice-Coil-Aktuatoren 211, 212; 221, 222 eines Paares jeweils gegenläufig betrieben werden bzw. die gesamte Mikro-Verschiebeeinrichtung 200 asymmetrisch angesteuert wird. Aufgrund der Möglichkeit, die Position des Objektträgers 10 in mit Hilfe des Referenzgitters in drei Freiheitsgraden X, Y, φ zu messen, lässt sich daher mit dem in den Fig. 1-3 gezeigten Ausführungsbeispiel der Positioniervorrichtung 1 insgesamt eine Regelung in drei Freiheitsgraden X, Y, φ realisieren. Dabei ist es vollkommen ausreichend, wenn die Makro-Verschiebeeinrichtung 100 lediglich eine Positionierbarkeit in zwei Freiheitsgraden X, Y erlaubt.

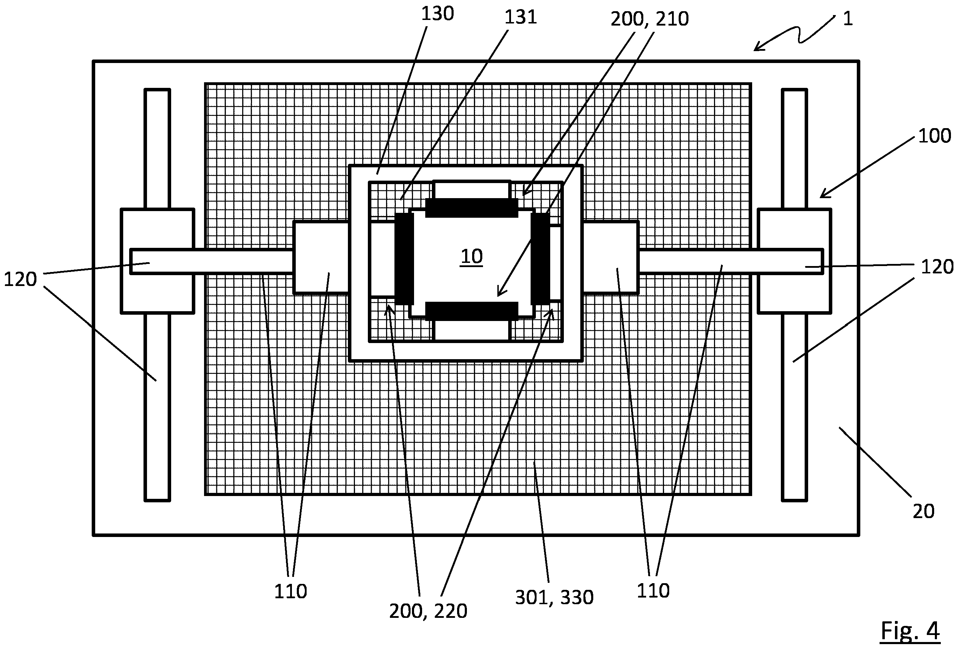

In Fig. 4 ist eine schematische Darstellung des Ausführungsbeispiels der erfindungsgemässen Positioniervorrichtung 1 von oben gezeigt. In der Darstellung sind der Übersichtlichkeit halber nur den Objektträger 10, die Makro-Verschiebeinrichtung 100, die Mikro-Verschiebeeinrichtung 200 und ein zweidimensionales Gittermuster als gemeinsames Referenzsystem 301 bzw. als gemeinsamer Encoder-Massstab 330. Das Referenzsystem 301 bzw. der Encoder-Massstab 330 ist relativ zum Basiselement 20 ortsfest. Wie weiter oben beschrieben ist, wird der Rahmen 130 der Makro-Verschiebeeinrichtung 100 mittels einer einachsigen Linearführungseinrichtung 110 entlang der ersten Makro-Achse X bewegt. Die Linearführungseinrichtung 110 wird im Ausführungsbeispiel mittels einer einachsigen Gantry-Verschiebeeinrichtung 120 entlang der zweiten Makro-Achse Y bewegt. Bei der Linearführungseinrichtung 110 und der Gantry-Verschiebeeinrichtung 120 handelt es sich um sogenannte Langhub-Aktuatoren, d.h. um Aktuatoren mit grosser Reichweite. Innerhalb der Öffnung 131 des Rahmens 130 wird der Objektträger 10 mittels der Mikro-Verschiebeeinrichtung 200 bewegt. Dazu dienen im Ausführungsbeispiel die Voice-Coil-Aktuatoren 211, 212; 221, 222. Der Objektträger 10 wird im Ausführungsbeispiel parallel zu einem zweidimensionalen Gittermuster bewegt, welches als gemeinsames Referenzsystem 301 bzw. als gemeinsamer Encoder-Massstab 330 für die Bestimmung der Absolutposition des Objektträgers 10 und der Absolutposition des Rahmens 130 dient, d.h. der Objektträger 10 verfügt über eine Mikro-Messeinrichtung 320 und der Rahmen 130 verfügt über eine Makro-Messeinrichtung 310. Mittels der Messeinrichtungen 310, 320 (in Fig. 4 nicht dargestellt) werden die Absolutpositionen relativ zum Gittermuster und somit relativ zum Basiselement 20 bestimmt.

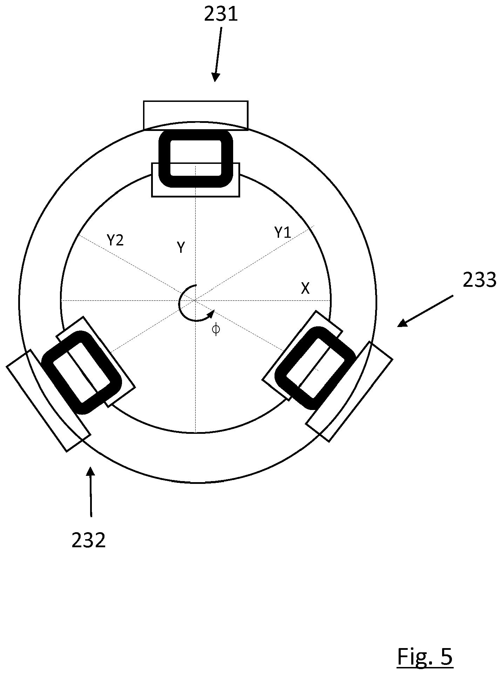

Fig. 5 zeigt eine alternative Ausgestaltung der Mikro-Verschiebeeinrichtung 200. Anstelle des orthogonalen bzw. rechtwinkligen Systems aus zwei Aktuator-Achsen X, Y mit jeweils einem Paar von Voice-Coil-Aktuatoren 211, 212; 221, 222 aufweist (vgl. Fig. 1-4), zeigt die in Fig. 5 dargestellte Ausführungsform eine Mikro-Verschiebeeinrichtung 200 mit drei Voice-Coil-Aktuatoren 231, 232, 233, die symmetrisch um eine zentrale Achse φ senkrecht zur Verschiebeebene angeordnet sind. In diesem Ausführungsbeispiel ist der Objektträger 10 als kreisrunde Platte ausgebildet. Entsprechend lässt sich ein derartiger Objektträger entlang dreier Linearachsen X, Y1, Y2 innerhalb einer Ebene verschieben oder alternativ betrachtet entlang zweier, insbesondere orthogonaler Linearachsen X, Y in der Ebene und um eine dazu senkrechte Drehachse φ. Alternativ wäre auch denkbar, dass der Objektträger eine dreieckige Form aufweist, wobei an jeder Seite des Dreiecks wenigstens ein Voice-Coil-Aktuator angeordnet ist.

Im Rahmen der Erfindung ist beispielsweise vorgesehen, dass es sich bei den Messeinrichtungen 310, 320 um Encoder-Leseköpfe, insbesondere um mehrdimensionale Encoder-Leseköpfe handelt. Encoder-Leseköpfe, welche geeignet sind, einen optischen Encoder-Massstab auszulesen, können beispielsweise Fotodetektoren enthalten, welche ein von der Lichtintensität abhängiges Signal erzeugen. Als eine dafür gegebenenfalls erforderliche Lichtquelle können beispielsweise Laserdioden und/oder Leuchtdioden (LEDs) verwendet werden.

## Patentansprüche

1. Positioniervorrichtung (1) zum Positionieren eines Objektes innerhalb einer Ebene, mit einem Objektträger (10) zum Aufnehmen des zu positionierenden Objekts (11), welcher parallel zur Ebene in wenigstens zwei Freiheitsgraden (X, Y) relativ zu einem Basiselement (20) mittels einer wenigstens zweidimensionalen Makro-Verschiebeeinrichtung (100) sowie einer wenigstens zweidimensionalen Mikro-Verschiebeeinrichtung (200) positionierbar ist, mit einer Positionsbestimmungs-Einrichtung (300) zum Bestimmen der Position des Objektträgers (10) relativ zum Basiselement (20) und mit einer Steuereinrichtung (400), die zum geregelten Positionieren des Objekts mit der Makro- und der Mikro-Verschiebeeinrichtung (100, 200) sowie der Positionsbestimmungs-Einrichtung (300) wirkverbunden ist, **dadurch gekennzeichnet, dass** die Positionsbestimmungs-Einrichtung (300) dazu eingerichtet ist, die Absolutposition des Objektträgers (10) in den wenigstens zwei Freiheitsgraden (X, Y) direkt in Bezug auf ein relativ zum Basiselement (20) ortsfestes Referenzsystem (301) zu bestimmen.

2. Positioniervorrichtung (1) nach Anspruch 1, **dadurch gekennzeichnet, dass** die Steuereinrichtung (400) dazu ausgebildet ist, die Position des Objektträgers (10) in den wenigstens zwei Freiheitsgraden (X, Y) mittels der Mikro-Verschiebeeinrichtung (200) direkt in Bezug auf das relativ zum Basiselement (20) ortsfeste Referenzsystem (301) zu regeln.

3. Positioniervorrichtung (1) nach einem der vorstehenden Ansprüche, **dadurch gekennzeichnet, dass** die Makro-Verschiebeeinrichtung (100) als ein bewegtes System einen in wenigstens den zwei Freiheitsgraden (X, Y) bewegbaren Rahmen (130) mit einer Rahmenöffnung (131) aufweist und der Objektträger (10) innerhalb der Rahmenöffnung (130) mittels der Mikro-Verschiebeeinrichtung (200) in wenigstens den zwei Freiheitsgraden (X, Y) relativ zum Basiselement (20) positionierbar ist.

4. Positioniervorrichtung (1) nach einem der vorstehenden Ansprüche, **dadurch gekennzeichnet, dass** die Mikro-Verschiebeeinrichtung (200) zum Erzeugen einer Mikro-Verschiebebewegung entlang wenigstens einer ersten Mikro-Achse (X) und einer zweiten Mikro-Achse (Y) eine wenigstens zweiachsige elektrodynamische Verschiebeeinrichtung (210, 220), bevorzugt eine wenigstens zweiachsige Voice-Coil-Verschiebeeinrichtung (210, 220) umfasst.

5. Positioniervorrichtung (1) nach Anspruch 4, **dadurch gekennzeichnet, dass** die Mikro-Verschiebeeinrichtung (200) zum Erzeugen einer Mikro-Verschiebebewegung entlang wenigstens einer ersten Mikro-Achse (X) und einer zweiten Mikro-Achse (Y) eine wenigstens zweiachsige Voice-Coil-Verschiebeeinrichtung (210, 220) umfasst, welche für die erste und/oder die zweite Mikro-Achse (X, Y) jeweils wenigstens ein Paar Voice-Coil-Aktuatoren (211, 212; 221, 222) mit jeweils wenigstens einer Spuleneinrichtung (211.1, 212.1; 221.1, 222.1) und wenigstens einer Magneteinrichtung (211.2, 212.2; 221.2, 222.2) aufweist, wobei die jeweiligen Voice-Coil-Aktuatoren (211, 212; 221, 222) eines Paares vorzugsweise bezüglich der jeweiligen Mikro-Achse (X, Y) an zwei gegenüberliegenden Seiten des Objektträgers (10) angeordnet sind.

6. Positioniervorrichtung (1) nach Anspruch 5, **dadurch gekennzeichnet, dass** die jeweilige Spuleneinrichtung (211.1, 212.1; 221.1, 222.1) im bewegten System der Makro-Verschiebeeinrichtung (100) und die jeweilige Magneteinrichtung (211.2, 212.2; 221.2, 222.2) im bewegten System der Mikro-Verschiebeeinrichtung (200) angeordnet ist.

7. Positioniervorrichtung (1) nach einem der vorstehenden Ansprüche, **dadurch gekennzeichnet, dass** die Makro-Verschiebeeinrichtung (100) und der Objektträger (10) über die Mikro-Verschiebeeinrichtung (200) miteinander gekoppelt sind, wobei die Kopplung bevorzugt berührungsfrei ist, wobei die Kopplung weiter bevorzugt über eine magnetische Lagerung erfolgt.

8. Positioniervorrichtung (1) nach einem der vorgenannten Ansprüche, **dadurch gekennzeichnet, dass** die Positionsbestimmungs-Einrichtung (300) eine Encoder-Einrichtung aufweist, umfassend einen insbesondere relativ zum Basiselement (20) ortsfest angeordneten Encoder-Massstab (330) als Referenzsystem (301) für die Mikro-Verschiebeeinrichtung (200) sowie wenigstens eine im bewegten System der Mikro-Verschiebeeinrichtung (200) angeordnete Mikro-Messeinrichtung (320) zum Auslesen des Encoder-Massstabs (330) und zum Erzeugen eines der Absolutposition des bewegten Systems der Mikro-Verschiebeeinrichtung (200) entsprechenden Mikro-Positionssignals.

9. Positioniervorrichtung (1) nach Anspruch 8, **dadurch gekennzeichnet, dass** die Encoder-Einrichtung eine optische, magnetische, kapazitive oder induktive Encoder-Einrichtung ist.

10. Positioniervorrichtung (1) nach Anspruch 8 oder Anspruch 9, **dadurch gekennzeichnet, dass** der Encoder-Massstab (330) ein parallel zur Ebene und relativ zum Basiselement (20) ortsfest angeordnetes Referenzgitter (330), insbesondere ein aus der aus einem optisches Beugungsgitter, einem optischen Reflexionsgitter und einer zweidimensional periodisch variierenden Magnetisierungsstruktur bestehenden Gruppe ausgewähltes Referenzgitter (330) aufweist.

11. Positioniervorrichtung (1) nach einem der Ansprüche 8 bis 10, **dadurch gekennzeichnet, dass** der Encoder-Massstab (330) ein parallel zur Ebene und relativ zum Basiselement (20) ortsfest angeordnetes Referenzstreifenmuster, insbesondere ein aus der aus einem optisches Beugungsstreifenmuster, einem optischen Reflexionsstreifenmuster und einer eindimensional periodisch variierenden Magnetisierungsstruktur bestehenden Gruppe ausgewähltes Referenzstreifenmuster aufweist.

12. Positioniervorrichtung (1) nach einem der vorgenannten Ansprüche, **dadurch gekennzeichnet, dass** die Positionsbestimmungs-Einrichtung (300) dazu eingerichtet ist, die Absolutposition eines bewegten Systems der Makro-Verschiebeeinrichtung (100) und die Absolutposition eines bewegten Systems der Mikro-Verschiebeeinrichtung (200) in wenigstens zwei Freiheitsgraden (X, Y) jeweils direkt in Bezug auf ein relativ zum Basiselement (20) ortsfestes Referenzsystem (301) zu bestimmen,
wobei die Absolutposition des bewegten Systems der Makro-Verschiebeeinrichtung (100) und die Absolutposition des bewegten Systems der Mikro-Verschiebeeinrichtung (200) bevorzugt in Bezug auf ein gemeinsames relativ zum Basiselement (20) ortsfestes Referenzsystem (301) bestimmt werden.

13. Positioniervorrichtung (1) nach Anspruch 12, **dadurch gekennzeichnet, dass** die Steuereinrichtung (400) dazu ausgebildet ist, unabhängig voneinander die Position des bewegten Systems der Makro- und der Mikro-Verschiebeeinrichtung (100, 200) in wenigstens zwei Freiheitsgraden (X, Y) jeweils direkt in Bezug auf das gemeinsame, relativ zum Basiselement (20) ortsfeste Referenzsystem (301) zu regeln.

14. Positioniervorrichtung (1) nach einem der Ansprüche 12 bis 13, **dadurch gekennzeichnet, dass**
• die Positionsbestimmungs-Einrichtung (300) eine kombinierte Encoder-Einrichtung aufweist, umfassend einen gemeinsamen, insbesondere relativ zum Basiselement (20) ortsfest angeordneten Encoder-Massstab (330) für die Makro- bzw. Mikro-Verschiebeeinrichtung (100, 200) sowie jeweils wenigstens eine im bewegten System der Makro- bzw. Mikro-Verschiebeeinrichtung (100, 200) angeordnete Makro- und Mikro-Messeinrichtung (310, 320) zum Auslesen des gemeinsamen Encoder-Massstabs (330) und zum Erzeugen eines der Absolutposition des bewegten Systems der Makro- bzw. Mikro-Verschiebeeinrichtung (100, 200) entsprechenden Makro- bzw. Mikro-Positionssignals; oder
• die Positionsbestimmungs-Einrichtung (300) für die Makro- und die Mikro-Verschiebeeinrichtung (100, 200) jeweils wenigstens eine Makro- bzw. Mikro-Encoder-Einrichtung aufweist, umfassend jeweils wenigstens einen insbesondere relativ zum Basiselement (20) ortsfest angeordneten Makro- bzw. Mikro-Encoder-Massstab sowie jeweils wenigstens eine im bewegten System der Makro- bzw. Mikro-Verschiebeeinrichtung (100, 200) angeordnete Makro- bzw. Mikro-Messeinrichtung zum Auslesen des Makro- bzw. Mikro-Encoder-Massstabs und zum Erzeugen eines der Absolutposition des bewegten Systems der Makro- bzw. Mikro-Verschiebeeinrichtung (100, 200) entsprechenden Makro- bzw. Mikro-Positionssignals; oder
• dass die Makro-Verschiebeeinrichtung (100) eine erste und zweite Verschiebeeinrichtung (110, 120) zum Erzeugen einer Makro-Verschiebebewegung entlang einer ersten und einer zweiten Makro-Achse (X, Y) aufweist, wobei die erste Verschiebeeinrichtung (110) im bewegten System der zweiten Verschiebeeinrichtung (120) angeordnet ist, und wobei die Positionsbestimmungs-Einrichtung (300) aufweist:
- wenigstens eine erste Makro-Encoder-Einrichtung mit wenigstens einem ersten Makro-Encoder-Massstab im bewegten System der zweiten Verschiebeeinrichtung (120) und wenigstens einer im bewegten System der ersten Verschiebeeinrichtung (110) angeordneten ersten Makro-Messeinrichtung zum Auslesen des ersten Makro-Encoder-Massstabs und zum Erzeugen eines der Absolutposition des bewegten Systems der ersten Verschiebeeinrichtung (110) entsprechenden ersten Makro-Positionssignals entlang der ersten Makro-Achse,
- wenigstens eine zweite Makro-Encoder-Einrichtung mit wenigstens einem insbesondere relativ zum Basiselement (20) ortsfest angeordneten zweiten Makro-Encoder-Massstab und wenigstens einer im bewegten System der zweiten Verschiebeeinrichtung (120) angeordneten zweiten Makro-Messeinrichtung zum Auslesen des zweiten Makro-Encoder-Massstabs und zum Erzeugen eines der Absolutposition des bewegten Systems der zweiten Verschiebeeinrichtung (120) entsprechenden zweiten Makro-Positionssignals entlang der zweiten Makro-Achse, und
- wenigstens eine Mikro-Encoder-Einrichtung mit wenigstens einem, insbesondere relativ zum Basiselement (20) ortsfest angeordneten Mikro-Encoder-Massstab sowie wenigstens einer im bewegten System der Mikro-Verschiebeeinrichtung (100, 200) angeordneten Mikro-Messeinrichtung zum Auslesen des Mikro-Encoder-Massstabs und zum Erzeugen eines der Absolutposition des bewegten Systems der Mikro-Verschiebeeinrichtung (100, 200) entsprechenden Mikro-Positionssignals.

15. Positioniervorrichtung (1) nach Anspruch 14, **dadurch gekennzeichnet, dass** sich der gemeinsame Encoder-Massstab (330), der Makro-Encoder-Massstab und/oder der Mikro-Encoder-Massstab, insbesondere das Referenzgitter (330), wenigstens über einen gemeinsamen maximalen Verschiebebereich der Makro- und Mikro-Verschiebeeinrichtung (100, 200) erstreckt; und/oder dass sich der erste Makro-Encoder-Massstab und/oder der zweite Makro-Encoder-Massstab über einen maximalen Verschiebebereich der ersten bzw. zweiten Verschiebeeinrichtung entlang der ersten bzw. zweiten Makro-Achse erstreckt.

16. Positioniervorrichtung (1) nach einem der vorhergehenden Ansprüche, **dadurch gekennzeichnet, dass** die Makro-Verschiebeeinrichtung (100) zum Erzeugen einer Makro-Verschiebebewegung entlang wenigstens einer ersten Makro-Achse (X) und einer zweiten Makro-Achse (Y) eine wenigstens zweiachsige, insbesondere gestufte Linearführungs-Verschiebeeinrichtung aufweist, insbesondere eine zweiachsige, gestufte Kreuztisch-Verschiebeeinrichtung oder eine Gantry-Verschiebeinrichtung (120) entlang der zweiten Makro-Achse (Y) und eine darauf abgeordnete Linearführungs-Verschiebeeinrichtung (110) entlang der ersten Makro-Achse (X) oder eine zweiachsige Doppelgantry-Verschiebeeinrichtung.

17. Positioniervorrichtung (1) nach Anspruch 16, **dadurch gekennzeichnet, dass** die Makro-Verschiebeeinrichtung (100) zum Erzeugen der Makro-Verschiebebewegung entlang der ersten und/oder der zweiten Makro-Achse (X, Y) jeweils wenigstens einen Linearantrieb (111, 121, 122) aufweist, wobei der Linearantrieb (111, 121, 122) bevorzugt aus der aus Linearmotorantrieb, Servoantrieb, Spindelantrieb, Riemenantrieb, Kettenantrieb, Pneumatikantrieb und Hydraulikantrieb bestehenden Gruppe ausgewählt ist.

18. Positioniervorrichtung (1) nach einem der vorhergehenden Ansprüche, **dadurch gekennzeichnet, dass** die Mikro-Verschiebeeinrichtung (200) zum Erzeugen einer Mikro-Verschiebebewegung in drei Freiheitsgraden (X, Y, φ) ausgebildet ist; und/oder dass die Positionsbestimmungs-Einrichtung (300), insbesondere die kombinierte Encoder-Einrichtung, dazu ausgebildet ist, die Position des bewegten Systems der Mikro-Verschiebeeinrichtung (200) in Bezug auf das gemeinsame Referenzsystem (301) in drei Freiheitsgraden (X, Y, φ) zu bestimmen; und/oder dass die Steuereinrichtung dazu ausgebildet ist, die Position des bewegten Systems der Mikro-Verschiebeeinrichtung (200) in drei Freiheitsgraden (X, Y, φ) in Bezug auf das gemeinsame Referenzsystem (301) zu regeln.

19. Positioniervorrichtung (1) nach einem der vorhergehenden Ansprüche, **dadurch gekennzeichnet, dass** der Objektträger (10) auf dem Basiselement (20) berührungsfrei gelagert ist,
wobei der Objektträger (10) bevorzugt mittels eines Fluidfilms gelagert ist, welcher weiter bevorzugt mittels wenigstens einer Fluidfilm-Lagerungseinrichtung (30) erzeugt wird, welche insbesondere auf einer dem Basiselement (20) zugewandten Seite des Objektträgers (10) angeordnet ist und/oder eine integrierte Vakuum- oder Magnetvorspannungs-Einrichtung aufweist und/oder wobei der Objektträger (10) bevorzugt mittels einer Magnetlagerung gelagert ist.

20. Vorrichtung zum Prozessieren eines Werkstücks, insbesondere zum Bearbeiten, Belichten und/oder Inspizieren eines Wafers, mit einer Prozessiereinheit und mit wenigstens einer Positioniervorrichtung (1) nach einem der vorhergehenden Ansprüche zum Positionieren des Werkstücks innerhalb einer Ebene in wenigstens zwei Freiheitsgraden relativ zur Prozessiereinheit.
